# EUROPEAN PATENT APPLICATION

(11) **EP 4 123 693 A1**
(43) Date of publication of application: **25.01.2023**
(21) Application number: 22183265.2
(22) Date of filing: 06.07.2022
(51) Int. Cl.: H01L 21/78, H01L 21/268

(54) **METHOD FOR THINNING WAFER**

(30) Priority: 06.07.2021 CN 202110764260
(71) Applicant: Huawei Digital Power Technologies Co., Ltd., Shenzhen, 518043 (CN)
(72) Inventor: GAO, Bo, Shenzhen, 518129 (CN); HUANG, Boning, Shenzhen, 518129 (CN); WAN, Yuxi, Shenzhen, 518129 (CN)
(74) Representative: Gill Jennings & Every LLP

(57) **Abstract**

Embodiments of this application relate to the field of semiconductor technologies, and provide a method for thinning a wafer, to resolve problems of a low yield, a complex process, and high preparation costs of a SiC power device. The wafer may alternatively be understood as a composite substrate, and includes a first silicon carbide layer, a dielectric layer, and a second silicon carbide layer that are disposed in a stacked manner. The wafer has a first side and a second side that are opposite to each other, and a side that is of the second silicon carbide layer and that is away from the first silicon carbide layer is the first side of the wafer. The method for thinning a wafer includes: temporarily bonding a temporary substrate carrier to the wafer at the second side; and performing laser irradiation on the wafer from the first side, so that energy of a laser is focused for ablation at an interface between the second silicon carbide layer and the dielectric layer, and the second silicon carbide layer is separated from the dielectric layer.

## Description

### TECHNICAL FIELD

This application relates to the field of semiconductor technologies, and in particular, to a method for thinning a wafer.

### BACKGROUND

A silicon carbide (SiC) material has excellent physical characteristics such as a wide bandgap, high critical breakdown field strength, and high thermal conductivity, so that a SiC power device has features such as high voltage resistance, high temperature resistance, a fast switching speed, and a low switching loss. The SiC power device is widely used in fields such as space and aerospace, a smart grid, rail transport, new energy power generation, an electric vehicle, and industrial power supply.

To reduce on-resistance of the SiC power device and improve device performance, generally, after a film layer structure of the SiC power device is prepared, thinning processing needs to be performed on a SiC substrate. However, in this case, a large quantity (for example, nearly 200 µm to 300 µm) of SiC materials are ground and wasted. In addition, because hardness of the SiC material almost reaches a diamond level, a conventional mechanical thinning rate is small, damage to a grinding head is severer, and there is a high risk of rupture of the SiC substrate. Consequently, preparation costs and sale prices of the SiC power device remain high. This greatly restricts promotion and application of the SiC power device in various fields.

### SUMMARY

Embodiments of this application provide a method for thinning a wafer, to resolve problems of a low yield, a complex process, and high preparation costs of a SiC power device.

To achieve the foregoing objectives, this application uses the following technical solutions.

According to a first aspect, a method for thinning a wafer is provided. The method may be applied to thinning of a composite substrate in a semiconductor component. The wafer is alternatively understood as a composite substrate. The wafer includes a first silicon carbide layer, a dielectric layer, and a second silicon carbide layer that are disposed in a stacked manner. The wafer has a first side and a second side that are opposite to each other, and a side that is of the second silicon carbide layer and that is away from the first silicon carbide layer is the first side of the wafer. The method for thinning a wafer includes: temporarily bonding a temporary substrate carrier to the wafer on the second side; and performing laser irradiation on the wafer from the first side, so that energy of a laser is focused for ablation at an interface between the second silicon carbide layer and the dielectric layer, and the second silicon carbide layer is separated from the dielectric layer.

According to the method for thinning a wafer provided in this embodiment of this application, the wafer is of a sandwich stacked structure, the wafer includes the dielectric layer, and a refractive index of the dielectric layer is different from that of the second silicon carbide layer. Therefore, after the laser is irradiated into the wafer from a surface that is of the second silicon carbide layer and that is away from the first silicon carbide layer, the laser is easily focused and absorbed at the interface between the dielectric layer and the second silicon carbide layer. The energy of the laser is increased to reach a melting point of the dielectric layer, so that the second silicon carbide layer can be debonded from the first silicon carbide layer, to thin the wafer. The debonded second silicon carbide layer can be reused to prepare a new wafer. Therefore, the wafer is thinned by using the method for thinning a wafer provided in this embodiment of this application, so that preparation costs of the semiconductor component can be reduced.

In a possible embodiment, an absorption coefficient of the second silicon carbide layer for the laser is less than an intrinsic absorption coefficient. The second silicon carbide layer is characterized by a low absorption coefficient for the laser or transparency to the laser, to reduce a laser energy loss of the second silicon carbide layer and improve focused ablation effect.

In a possible embodiment, non-linear absorption of the laser occurs at the interface between the second silicon carbide layer and the dielectric layer.

In a possible embodiment, a bonding temperature of temporary bonding is less than or equal to 300°C. In this way, impact on a switch functional component in the semiconductor component caused by an excessively high temperature in a temporary bonding process (for example, melting of a metal structure in the switch functional component) can be avoided.

In a possible embodiment, a melting point of the temporary substrate carrier is greater than a bonding temperature of temporary bonding. In this way, it can be avoided that in the temporary bonding process, the temporary substrate carrier is dissolved and cannot support the semiconductor component.

In a possible embodiment, the temporarily bonding a temporary substrate carrier to the wafer on the second side includes: temporarily bonding the temporary substrate carrier to the wafer on the second side by using temporary bonding adhesive. A process is mature and costs are low.

In a possible embodiment, the performing laser irradiation on the wafer from the first side includes: performing laser irradiation on the wafer from the first side by using an infrared laser. A process is mature and costs are low.

In a possible embodiment, the method for thinning a wafer further includes: processing a surface that is of the first silicon carbide layer and that is away from the temporary substrate carrier, to remove a residue of the dielectric layer. The surface that is of the first silicon carbide layer and that is away from the temporary substrate carrier is processed, so that the surface that is of the first silicon carbide layer and that is away from the temporary substrate carrier meets a requirement such as roughness. This facilitates subsequent manufacturing of a structure such as a metal electrode.

In a possible embodiment, the processing a surface that is of the first silicon carbide layer and that is away from the temporary substrate carrier includes: processing, through at least one of wet etching, dry etching, or cleaning, the surface that is of the first silicon carbide layer and that is away from the temporary substrate carrier.

In a possible embodiment, the switch functional component is further disposed on the second side of the wafer. The temporarily bonding a temporary substrate carrier to the wafer on the second side includes: temporarily bonding the temporary substrate carrier to the switch functional component. A process of thinning the wafer is performed after the switch functional component is disposed on the wafer. Therefore, the method for thinning a wafer provided in this embodiment of this application is compatible with a high-temperature process in a semiconductor component preparation process.

### BRIEF DESCRIPTION OF DRAWINGS

FIG. 1 is a diagram of an application scenario of an uninterruptible power system according to an embodiment of this application;
FIG. 2 is a schematic diagram of a structure of a metal-oxide-semiconductor field-effect transistor according to an embodiment of this application;
FIG. 3 is a diagram of a thinning process of a SiC homoepitaxial layer according to an embodiment of this application;
FIG. 4 is a diagram of another thinning process of a SiC homoepitaxial layer according to an embodiment of this application;
FIG. 5A is a schematic diagram of a structure of a semiconductor component according to an embodiment of this application;
FIG. 5B is a schematic diagram of another structure of a semiconductor component according to an embodiment of this application;
FIG. 6A is a flowchart of a method for thinning a wafer according to an embodiment of this application;
FIG. 6B is a process diagram of a method for thinning a wafer according to an embodiment of this application;
FIG. 7A is a flowchart of another method for thinning a wafer according to an embodiment of this application;
FIG. 7B is a process diagram of another method for thinning a wafer according to an embodiment of this application;
FIG. 8A is a diagram of a structure of a thinned wafer in a semiconductor component according to an embodiment of this application; and
FIG. 8B is a diagram of a preparation process of a semiconductor component in a subsequent process according to an embodiment of this application.

Reference numerals:
1-substrate; 2-semiconductor layer; 3-well region; 4-source region; 5-contact region; 6-insulating film; 7-interlayer insulating film; 10-first silicon carbide layer; 20-dielectric layer; 30-second silicon carbide layer; 41-first bonding layer; 42-transition layer; 43-second bonding layer; 44-third bonding layer; 50-temporary substrate carrier; 100-wafer; 200-switch functional device; 300-switch functional component; and 1000-semiconductor component.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The following terms "first" and "second" are merely intended for ease of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of' means two or more than two.

In embodiments of this application, unless otherwise specified and limited, the term "electrical connection" may be a direct electrical connection, or may be an indirect electrical connection through an intermediate dielectric.

In embodiments of this application, the word "example", "for example", or the like is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example" or the like is intended to present a relative concept in a specific manner.

In embodiments of this application, the term "and/or" describes an association relationship between associated objects and may indicate three relationships. For example, A and/or B may indicate the following cases: Only A exists, both A and B exist, and only B exists, where A and B may be singular or plural. The character "/" usually indicates an "or" relationship between the associated objects.

In embodiments of this application, for example, "upper", "lower", "left", "right", "front", and "rear" are used to explain that structures and motion directions of different components in this application are relative. These indications are appropriate when the components are in positions shown in the figure. However, if descriptions of the positions of the components change, these direction indications change accordingly.

An embodiment of this application provides an electronic device. The electronic device may be, for example, a charging pile, an uninterruptible power system (uninterruptible power system, UPS), a photovoltaic inverter, or a motor drive power supply. A specific form of the electronic device is not specifically limited in embodiments of this application.

A metal-oxide-semiconductor field-effect transistor (metal-oxide-semiconductor field-effect transistor, MOSFET) device is a semiconductor component, and has advantages such as low power consumption, stable performance, a strong radiation resistance capability, a convenient control mode, a small size, a light weight, a long service life, a strong anti-interference capability, a high working frequency, and a simple bias. Therefore, the metal-oxide-semiconductor field-effect transistor is widely used in an analog circuit and a digital circuit.

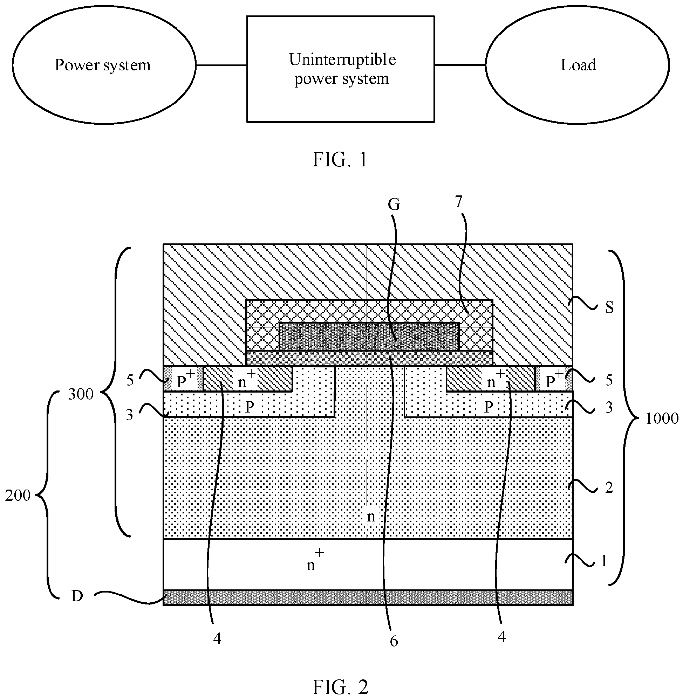

For example, the electronic device is a USP, and the UPS is a component configured to supply power to a load that requires a continuous power supply, for example, a computer. FIG. 1 is a schematic diagram of a UPS and a peripheral structure of the UPS. The UPS includes an input end and an output end. The input end of the UPS is connected to a power system, and the output end of the UPS is connected to a load, to implement uninterruptible power supply to the load.

The power system may be, for example, a power plant, a transformer station, or a mains transmission line. When the power system is in a normal state, a part of power supplied by the power system is transmitted to the load through the UPS, and a part of the power supplied by the power system is stored in the UPS. When the power system is in an abnormal state, the power system cannot transmit power to the load. In this case, the power stored in the UPS is transmitted to the load.

The load consumes the power supplied by the power system. For example, the load may be an electrical device in a factory; or may be a communication device, for example, a server, a processor, or a memory in a data center.

The UPS is an automatic system configured to supply power without interruption immediately when supplying power by the power system is interrupted or failed. If a voltage or a frequency of the power supplied by the power system changes, or power supply from the power system is interrupted or changed instantaneously, the UPS supplies power stably. This reduces a possibility of damage, a loss, or deletion of load data and a possibility of a shutdown or failure of a control device.

The UPS includes components such as a power device and a bidirectional switch, and is configured to implement the foregoing functions of the USP. An MOSFET device may be used as the power device in the foregoing USP. It should be understood that, when the MOSFET device is used as the power device, the electronic device provided in this embodiment of this application is not limited to the USP shown in FIG. 1, and any electronic device that needs to use a power device belongs to an application scenario of embodiments of this application.

For example, a structure of an MOSFET device is shown in FIG. 2. The MOSFET device includes a substrate 1, a semiconductor layer 2, well regions 3, source regions 4, contact regions 5, an insulating film 6, a gate (gate, G), a source (source, S), an interlayer insulating film 7, and a drain (drain, D)

The semiconductor layer 2, the well regions 3, the source regions 4, the contact regions 5, the insulating film 6, the gate G, the source S, the interlayer insulating film 7, and the drain D may be referred to as a switch functional device 200 of the MOSFET device. As the name implies, the switch functional device 200 of the MOSFET device is a combination of structures configured to implement a switch function of the MOSFET device, and the substrate 1 is configured to bear the switch functional device 200 of the MOSFET device.

The MOSFET device shown in FIG. 2 is used as an example. The structures included in the switch functional device 200 of the MOSFET device are located on two opposite sides of the substrate 1. In this embodiment of this application, a combination of structures that are included in the switch functional device 200, that are located on a same side, and that include the semiconductor layer 2 is referred to as a switch functional component 300. FIG. 2 is used as an example. The switch functional component 300 includes the semiconductor layer 2, the well regions 3, the source regions 4, the contact regions 5, the insulating film 6, the gate G, the source S, and the interlayer insulating film 7. In addition, in this embodiment of this application, a structure in which the switch functional component 300 is disposed on the substrate 1 is referred to as a semiconductor component 1000.

A working principle of the MOSFET device is as follows: A region that is in the well region 3 and that is located between the source region 4 and the semiconductor layer 2 is used as a conductive channel of the MOSFET device. When a voltage of the gate G is greater than a threshold voltage of the MOSFET device, the conductive channel is turned on; and electrons from the source S flow through the channel under effect of a voltage of the drain D, flow downward to the substrate 1, and reach the drain D, to form a source-drain current. When the voltage of the gate G is less than the threshold voltage of the MOSFET device, the conductive channel is turned off, and the source-drain current is turned off.

A silicon carbide (SiC) material has excellent physical characteristics such as a wide bandgap, high critical breakdown field strength, and high thermal conductivity, so that a power device using the SiC material as a substrate has features such as high voltage resistance, high temperature resistance, a fast switching speed, and a low switching loss. The power device is widely used in fields such as space and aerospace, a smart grid, rail transport, new energy power generation, an electric vehicle, and industrial power supply.

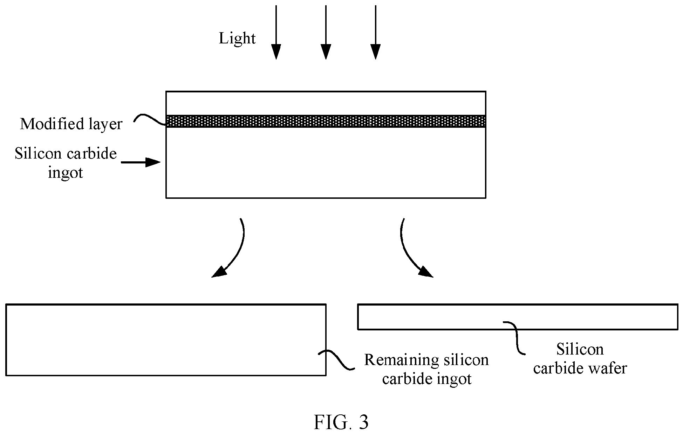

To reduce on-resistance of the SiC power device and improve device performance by thinning the SiC substrate, a method for thinning a SiC homoepitaxial layer is provided. As shown in FIG. 3, laser light that has transmittance to a monocrystalline SiC is irradiated on a SiC ingot, and is focused on an inner layer, to form a modified layer. A SiC wafer is formed from a monocrystalline SiC ingot by cutting off the monocrystalline SiC ingot along the modified layer under stress.

The foregoing method for thinning a SiC homoepitaxial layer is used, so that a cutting loss of the SiC ingot can be effectively reduced, cutting efficiency of the SiC ingot can be improved, and costs of the SiC substrate are reduced.

However, the foregoing method for thinning a SiC homoepitaxial layer mainly focuses on reducing the cutting loss of the SiC ingot and improving cutting efficiency, instead of debonding and reusing of the SiC wafer. Therefore, a problem of a waste of a substrate caused by thinning of the SiC substrate cannot be resolved.

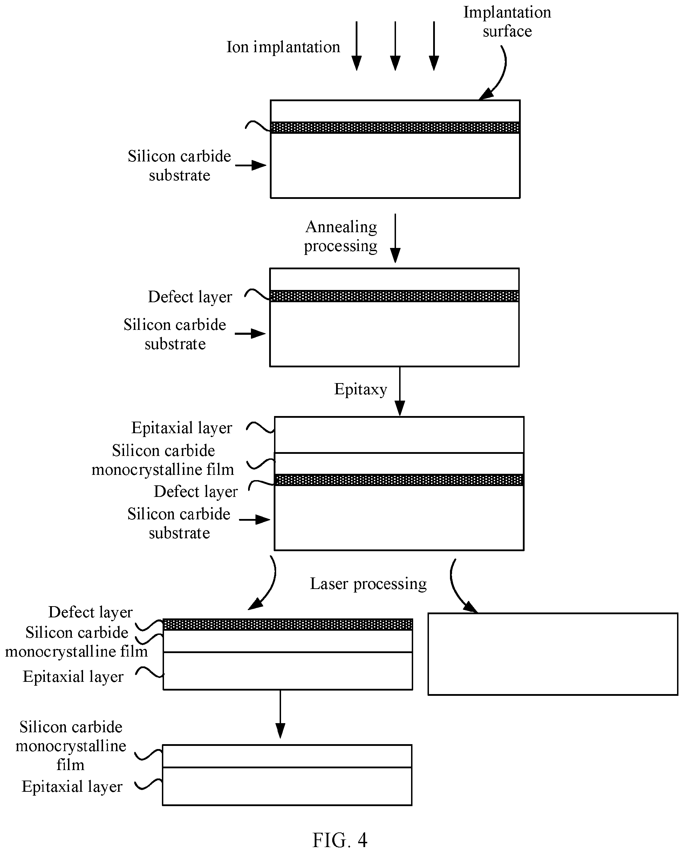

A method for thinning a SiC homoepitaxial layer is further provided. As shown in FIG. 4, a defect layer is manufactured near a surface of the SiC substrate by using an ion implantation method, and a defect caused by ion implantation on the surface of the SiC substrate is repaired through annealing processing. After an epitaxial layer is obtained through homoepitaxy on the surface of the SiC substrate, a laser is irradiated on the SiC substrate, and the laser is focused below the defect layer, so that the SiC substrate is separated from the defect layer, to thin the SiC substrate.

The foregoing method for thinning a SiC homoepitaxial layer is used, so that after being polished, a residual debonded SiC substrate may be reused to grow the SiC epitaxial layer. This can effectively improve utilization of the SiC substrate and reduce epitaxial production costs.

However, in the foregoing method for thinning a SiC homoepitaxial layer, because the SiC substrate undergoes epitaxy before laser debonding, the defect layer induced through ion implantation is annealed and repaired in an epitaxial high-temperature growth process. Therefore, during subsequent laser irradiation, it is difficult to implement laser absorption for the only residual defect layer, so that a success rate of separating the SiC substrate from the defect layer is very low. Therefore, the foregoing method for thinning a SiC homoepitaxial layer is not compatible with a high-temperature process.

To resolve the foregoing problem, an embodiment of this application further provides a method for thinning a wafer. The method for thinning a wafer can resolve problems that a mechanical thinning rate is low and damage to a grinding head is severer in the foregoing process of thinning the SiC substrate, and can also resolve problems that a rupture risk of the SiC substrate is extremely high and the SiC substrate is not compatible with the high-temperature process.

An example in which the method for thinning a wafer provided in this embodiment of this application is applied to a semiconductor component is used below for description. A structure of the semiconductor component is first briefly described.

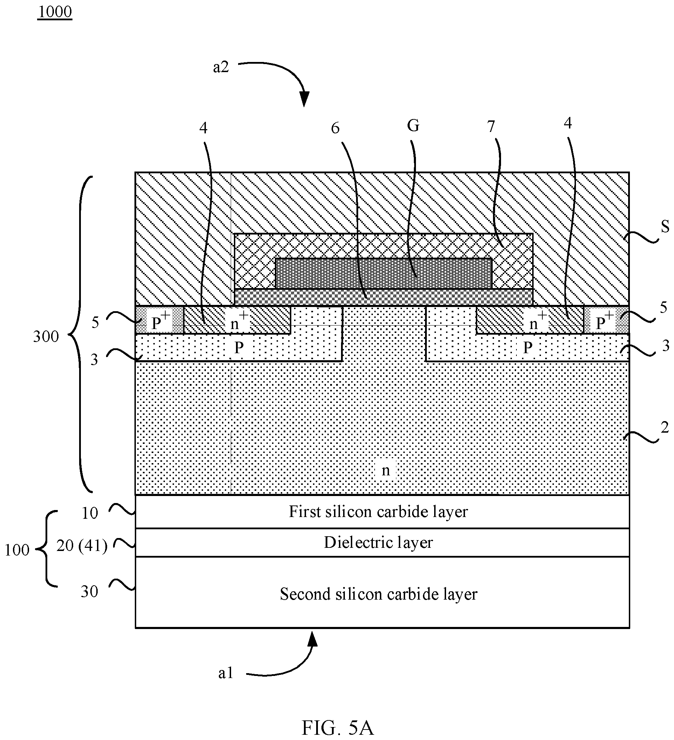

As shown in FIG. 5A, a semiconductor component 1000 includes a wafer 100 (or referred to as a composite substrate of the semiconductor component 1000) and a switch functional component 300 disposed on the wafer 100. The wafer 100 includes a first silicon carbide layer 10, a dielectric layer 30, and a second silicon carbide layer 30 that are disposed in a stacked manner. The wafer 100 has a first side and a second side that are opposite to each other, and a side that is of the second silicon carbide layer 30 and that is away from the first silicon carbide layer 10 is the first side of the wafer. The switch functional component 300 is disposed on a side that is of the first silicon carbide layer 10 and that is away from the second silicon carbide layer 30 (the second side of the wafer 100). The semiconductor component 1000 has a first surface a1 and a second surface a2 that are opposite to each other, and a surface that is of the second silicon carbide layer 30 and that is away from the first silicon carbide layer 10 is the first surface a1 of the semiconductor component 1000. That is, a surface that is of the wafer 100 and that is away from the switch functional component 300 is the first surface a1 of the semiconductor component 1000, and a surface that is of the switch functional component 300 and that is away from the wafer 100 is the second surface a2 of the semiconductor component 1000.

In some embodiments, the first silicon carbide layer 10 is of a high-quality (P-level) silicon carbide structure relative to the second silicon carbide layer 30, and the second silicon carbide layer 30 is of a low-quality (D-level) silicon carbide structure relative to the first silicon carbide layer 10. For example, defect density of a part or all of the second silicon carbide layer 30 is greater than defect density of the first silicon carbide layer 10.

In some embodiments, a lattice direction of the first silicon carbide layer 10 is deflected, in a lattice direction <0001>, in an interval greater than or equal to 0° and less than or equal to 8°.

For example, the first silicon carbide layer 10 is not deflected (deflected by 0°) in the lattice direction <0001>, the first silicon carbide layer 10 is deflected by 1° in the lattice direction <0001>, the first silicon carbide layer 10 is deflected by 2° in the lattice direction <0001>, the first silicon carbide layer 10 is deflected by 3° in the lattice direction <0001>, the first silicon carbide layer 10 is deflected by 4° in the lattice direction <0001>, the first silicon carbide layer 10 is deflected by 5° in the lattice direction <0001>, the first silicon carbide layer 10 is deflected by 6° in the lattice direction <0001>, or the first silicon carbide layer 10 is deflected by 7° in the lattice direction <0001>.

In some embodiments, thickness of the first silicon carbide layer 10 is less than or equal to 350 µm.

For example, the thicknesses of the first silicon carbide layer 10 is 300 µm, 250 µm, 200 µm, 150 µm, or 100 µm.

In some embodiments, a material of the first silicon carbide layer 10 is monocrystalline silicon carbide.

In some embodiments, the second silicon carbide layer 30 is also deflected, in the lattice direction <0001>, in the interval greater than or equal to 0° and less than or equal to 8°.

For example, a deflection angle in the lattice direction of the second silicon carbide layer 30 is the same as a deflection angle in the lattice direction of the first silicon carbide layer 10.

In some embodiments, thickness of the second silicon carbide layer 30 is less than or equal to 3000 µm.

For example, the thickness of the second silicon carbide layer 30 is 2500 µm, 2000 µm, 1500 µm, 1000 µm, or 500 µm.

The second silicon carbide layer 30 only needs to support and bear the first silicon carbide layer 10. If the second silicon carbide layer 30 is extremely thick, a waste of resources is caused and thickness of the wafer 100 is increased.

In some embodiments, a material of the second silicon carbide layer 30 include monocrystalline silicon carbide or polycrystalline silicon carbide.

In some embodiments, as shown in FIG. 5A, the first silicon carbide layer 10 is directly bonded to the second silicon carbide layer 30 in contact.

Based on this, it may be understood that, in a process in which the first silicon carbide layer 10 is directly bonded to the second silicon carbide layer 30 in contact, a first bonding layer 41 is naturally formed. Thickness of the first bonding layer 41 may be controlled by controlling time of bonding the first silicon carbide layer 10 and the second silicon carbide layer 30. In this case, the dielectric layer 20 in the wafer 100 is the first bonding layer 41 naturally formed in the process in which the first silicon carbide layer 10 is directly bonded to the second silicon carbide layer 30 in contact.

In some embodiments, thickness of the dielectric layer 20 is less than or equal to 5 nm. For example, the thickness of the dielectric layer 20 is 1 nm, 2 nm, 3 nm, or 4 nm.

If the thickness of the dielectric layer 20 is excessively large, both electrical conductivity and thermal conductivity of the wafer 100 are affected. Therefore, the thickness of the dielectric layer 20 is controlled to be less than or equal to 5 nm, and the thickness of the dielectric layer 20 is reduced as much as possible on the basis of ensuring direct contact bonding between the first silicon carbide layer 10 and the second silicon carbide layer 30.

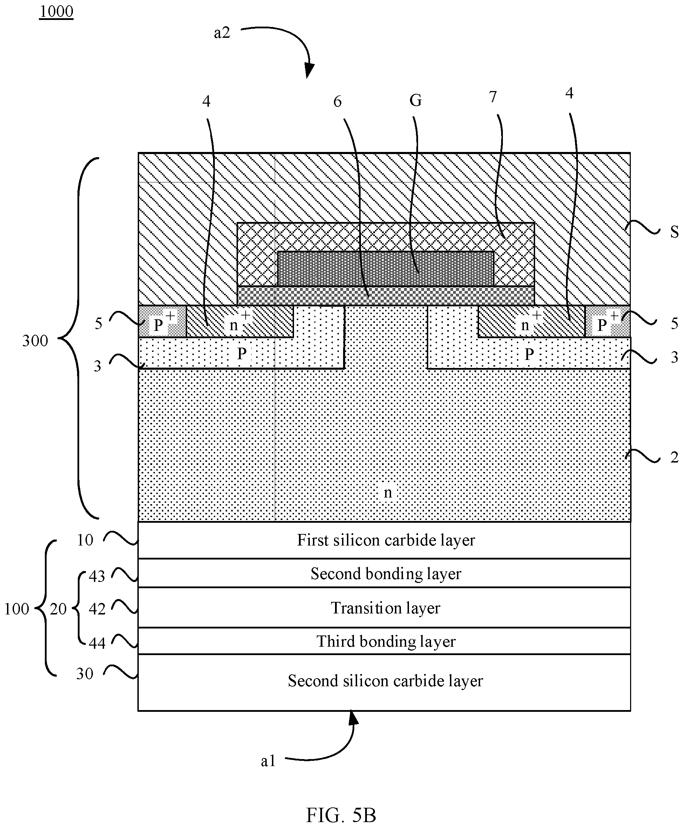

In some other embodiments, as shown in FIG. 5B, the first silicon carbide layer 10 is bonded to the second silicon carbide layer 30 through a transition layer 42.

A material of the transition layer 42 may include, for example, an insulation dielectric such as SiO2 (silicon oxide), Si3N4 (silicon nitride), or Al2O3 (aluminum oxide), or a conductive dielectric such as Si (silicon) or SiC (silicon carbide), or metal such as Al (aluminum), Cu (copper), Pt (platinum), Ni (nickel), Ti (titanium), Au (gold), and Cr (chromium), or a composite multilayer material of the foregoing plurality of materials.

In a process of bonding the first silicon carbide layer 10 to the second silicon carbide layer 30 through the transition layer 42, when the first silicon carbide layer 10 is bonded to the transition layer 42, a second bonding layer 43 is naturally formed. When the second silicon carbide layer 30 is bonded to the transition layer 42, a third bonding layer 44 is naturally formed.

Based on this, it may be understood that, in this case, the dielectric layer 20 in the wafer 100 includes the second bonding layer 43, the transition layer 42, and the third bonding layer 44.

In some embodiments, thickness of the dielectric layer 20 (a sum of thickness of the transition layer 42, the second bonding layer 43, and the third bonding layer 44) is less than or equal to 100 nm. For example, the sum of the thicknesses of the transition layer 42, the second bonding layer 43, and the third bonding layer 44 is 90 nm, 80 nm, 70 nm, or 60 nm.

If the sum of the thicknesses of the transition layer 42, the second bonding layer 43, and the third bonding layer 44 is extremely large, both the electrical conductivity and the thermal conductivity of the wafer are affected. Therefore, the sum of the thicknesses of the transition layer 42, the second bonding layer 43, and the third bonding layer 44 is controlled to be less than 100 nm, and the sum of the thicknesses of the transition layer 42, the second bonding layer 43, and the third bonding layer 44 is reduced as much as possible on the basis of ensuring stable bonding between a back surface a1 of the first silicon carbide layer 10 and a front surface b2 of the second silicon carbide layer 30.

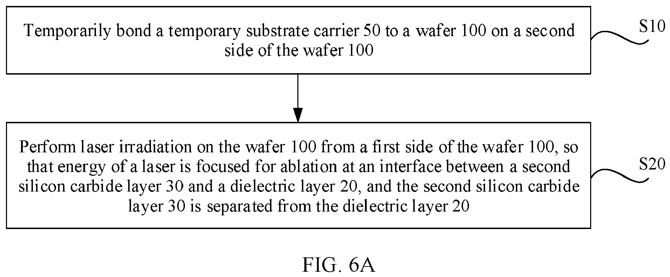

As shown in FIG. 6A, an example in which the switch functional component 300 is further disposed on the second side of the wafer 100 is used, to describe the method for thinning a wafer provided in an embodiment of this application. The method for thinning a wafer includes the following steps.

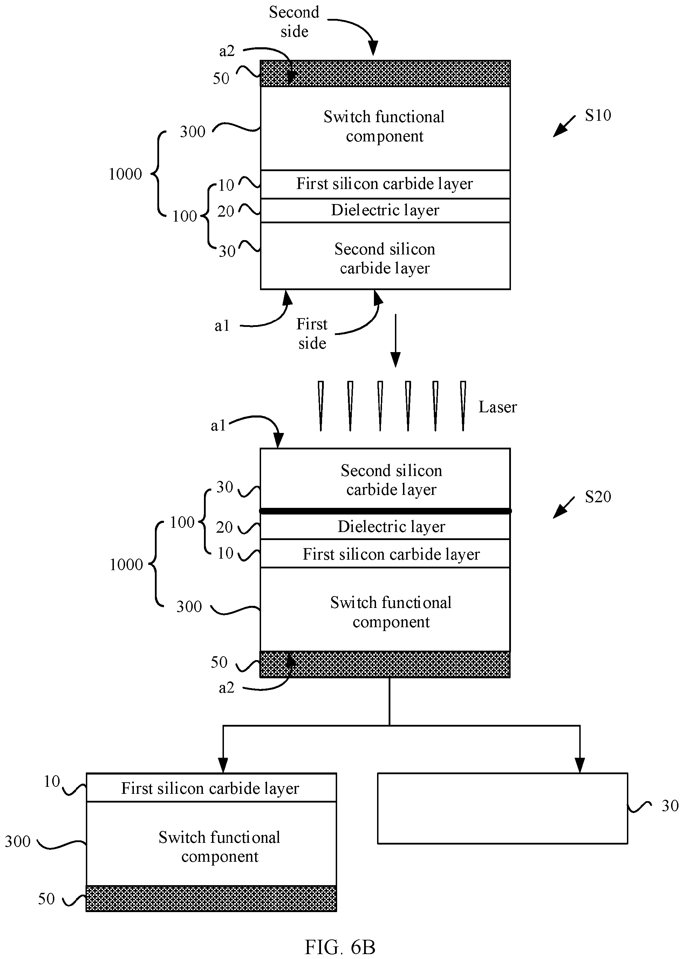

S10: As shown in FIG. 6B, temporarily bond a temporary substrate carrier 50 to the wafer 100 on the second side of the wafer 100.

When the switch functional component 300 is disposed on the second side of the wafer 100, the temporary substrate carrier 50 is temporarily bonded to the switch functional component 300 located on the second side of the wafer 100, to temporarily bond the temporary substrate carrier 50 to the wafer 100. In other words, the temporary substrate carrier 50 is temporarily bonded to the switch functional component 300 on the second surface a2 of the semiconductor component 1000.

To be specific, the temporary substrate carrier 50 is located on a side that is of the switch functional component 300 and that is away from the wafer 100, and the temporary substrate carrier 50 is temporarily bonded to the semiconductor component 1000.

Temporary bonding may be understood as bonding that can be restored. In a subsequent technological processing process, the temporarily bonded temporary substrate carrier 50 and semiconductor component 1000 may be debonded as required.

In some embodiments, a bonding temperature at which the temporary substrate carrier 50 is temporarily bonded to the wafer 100 is less than or equal to 300°C.

In this way, impact on the switch functional component 300 in the semiconductor component 1000 caused by an excessively high temperature in a temporary bonding process (for example, melting of a metal structure in the switch functional component 300) can be avoided.

A material of the temporary substrate carrier 50 is not limited in embodiments of this application. In some embodiments, a melting point of the temporary substrate carrier 50 is greater than the bonding temperature of temporary bonding.

In this way, it can be avoided that in the temporary bonding process, the temporary substrate carrier 50 is dissolved and cannot support the semiconductor component 1000.

In some embodiments, a method for temporarily bonding the temporary substrate carrier 50 to the wafer 100 is: temporarily bonding the temporary substrate carrier 50 to the wafer on the second side of the wafer 100 by using temporary bonding adhesive or paraffin.

To be specific, in some embodiments, the temporary bonding adhesive is used to temporarily bond the temporary substrate carrier 50 to the semiconductor component 1000 on the second surface a2 of the semiconductor component 1000.

In some other embodiments, the paraffin is used to temporarily bond the temporary substrate carrier 50 to the semiconductor component 1000 on the second surface a2 of the semiconductor component 1000.

S20: As shown in FIG. 6B, perform laser irradiation on the wafer 100 from the first side of the wafer 100, so that energy of a laser is focused for ablation at an interface between the second silicon carbide layer 30 and the dielectric layer 20, and the second silicon carbide layer 30 is separated from the dielectric layer 20.

To be specific, laser irradiation is performed on the wafer 100 from the first surface a1 of the semiconductor component 1000, so that the energy of the laser is focused for ablation at the interface between the second silicon carbide layer 30 and the dielectric layer 20, and the second silicon carbide layer 30 is separated from the dielectric layer 20.

When light is propagated in a dielectric, a phenomenon that light intensity attenuates with a propagation distance (penetration depth) is referred to as light absorption. Light absorption complies with an absorption law (the Beer-Lambert law). An absorption coefficient is a constant in the Beer-Lambert law (Beer-Lambert law). A symbol of the absorption coefficient is α, and the absorption coefficient is referred to as an absorption coefficient of a dielectric to monochromatic light. A larger absorption coefficient indicates more obvious light attenuation.

An intrinsic absorption coefficient is an optical absorption coefficient, in a dielectric, of an optical wavelength whose photon energy corresponds to a dielectric bandgap width, an optical absorption coefficient of an optical wavelength whose photon energy is greater than the dielectric bandgap width is greater than the intrinsic absorption coefficient, and an optical absorption coefficient of an optical wavelength whose photon energy is less than the dielectric bandgap is less than the intrinsic absorption coefficient.

Therefore, the second silicon carbide layer 30 is characterized by a low absorption coefficient for the laser or transparency to the laser, to reduce a laser energy loss of the second silicon carbide layer 30 and improve focused ablation effect.

For example, an absorption coefficient of the second silicon carbide layer 30 for a selected laser may be less than the intrinsic absorption coefficient by adjusting a wavelength of the laser.

In some embodiments, an infrared laser, an ultraviolet laser, or the like is used to perform laser irradiation on the wafer 100 from the first side of the wafer 100.

To be specific, the infrared laser, the ultraviolet laser, or the like is used to perform laser irradiation on the wafer 100 from the first surface a1 of the semiconductor component 1000.

In some embodiments, non-linear absorption of the laser occurs at the interface between the second silicon carbide layer 30 and the dielectric layer 20.

Non-linear absorption is a phenomenon that a coefficient at which a dielectric absorbs light is greater than the absorption coefficient under strong light.

Based on this, after the energy of the laser is focused for ablation at the interface between the second silicon carbide layer 30 and the dielectric layer 20, the dielectric layer 20 is naturally separated from the second silicon carbide layer 30, so that the second silicon carbide layer 30 is separated from the first silicon carbide layer 10 in the wafer 100.

After the second silicon carbide layer 30 debonded from the wafer 100 is cleaned, the second silicon carbide layer 30 can be reused to prepare a new wafer 100.

It is considered that after the energy of the laser is focused for ablation at the interface between the second silicon carbide layer 30 and the dielectric layer 20, and a residue of the dielectric layer 20 may still exist on the surface that is of the first silicon carbide layer 10 and that is away from the switch functional component 300.

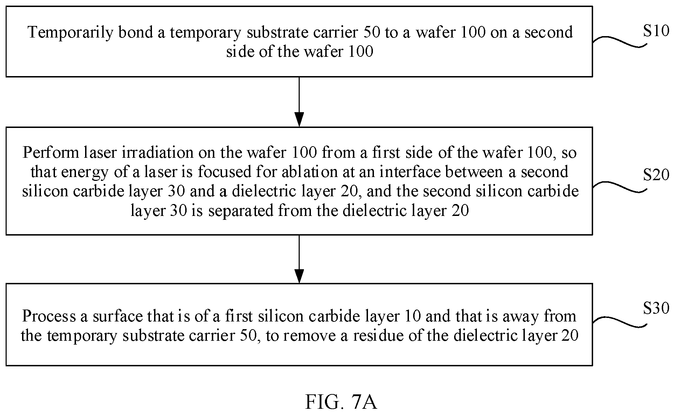

Therefore, in some embodiments, as shown in FIG. 7A, the method for thinning a wafer further includes the following step.

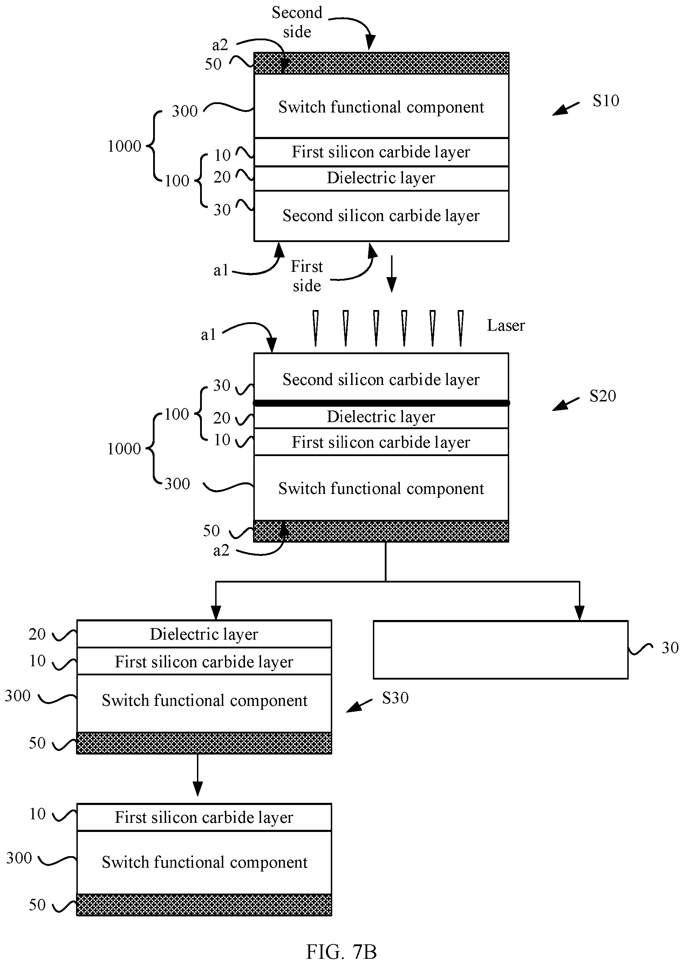

S30: As shown in FIG. 7B, process the surface that is of the first silicon carbide layer 10 and that is away from the temporary substrate carrier 50, to remove the residue of the dielectric layer 20.

In some embodiments, the surface that is of the first silicon carbide layer 10 and that is away from the temporary substrate carrier 50 is processed through at least one of wet etching, dry etching, or cleaning, to remove the residue of the dielectric layer 20.

After the residue of the dielectric layer 20 is removed, thinning of a silicon wafer of the wafer 100 is completed. A subsequent technological process may be performed as required.

In some embodiments, after the surface that is of the first silicon carbide layer 10 and that is away from the temporary substrate 50 is processed, roughness of the surface that is of the first silicon carbide layer 10 and that is away from the temporary substrate 50 is less than or equal to 0.5 nm.

In this way, another structure can be conveniently formed on the surface that is of the first silicon carbide layer 10 and that is away from the temporary substrate 50.

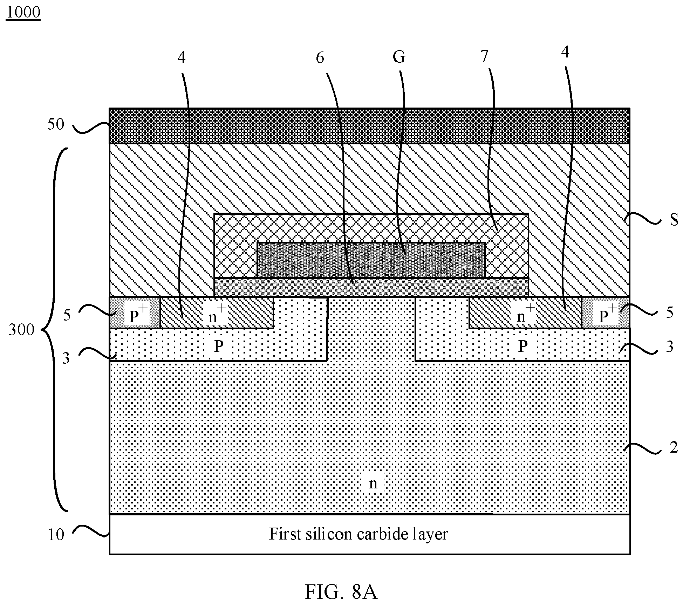

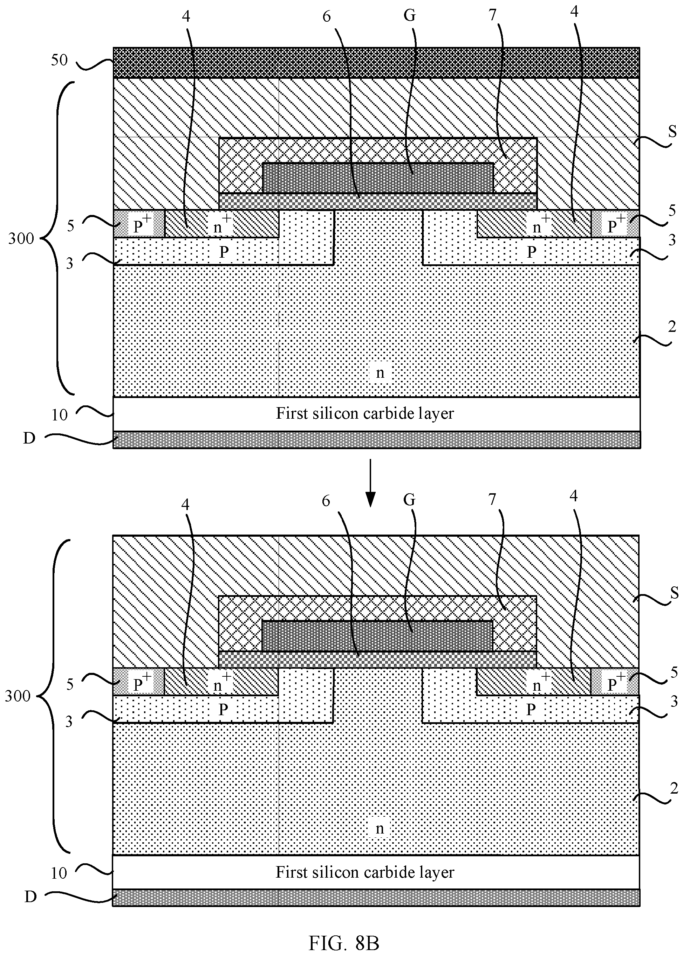

The MOSFET device shown in FIG. 2 is used as an example. After the wafer 100 is thinned, a structure obtained after the surface of the first silicon carbide layer 10 is cleaned includes, as shown in FIG. 8A, the first silicon carbide layer 10 and the switch functional component 300. Then, a subsequent process may be performed. As shown in FIG. 8B, a metal electrode (the drain D) is manufactured, and a process such as debonding is performed on the temporary substrate carrier 50 and the semiconductor component 1000, to finally complete manufacturing of the semiconductor component.

The surface that is of the first silicon carbide layer 10 and that is away from the temporary substrate carrier 50 is processed, so that the surface that is of the first silicon carbide layer 10 and that is away from the temporary substrate carrier 50 meets a requirement such as roughness. This facilitates subsequent manufacturing of a structure such as the metal electrode.

The following uses two specific examples to describe the method for thinning a wafer based on the composite substrate in the semiconductor component provided in embodiments of this application.

For example, in the semiconductor component 1000, the wafer 100 includes a high-quality monocrystalline first silicon carbide layer 10 whose thickness is 2 µm, an SiO2 dielectric layer 20 whose thickness is 20 nm, and a low-quality monocrystalline second silicon carbide layer 30 whose thickness is 350 µm.

Al2O3 substrates of a same size are selected as the temporary substrate carrier 50, and temporary bonding is performed between the temporary substrate carrier 50 and the functional device 200 of the semiconductor component 1000. A bonding temperature is 150°C.

A laser with a wavelength of 1064 nm is used to perform scanning and irradiation from a surface that is of the wafer 100 and that is away from the functional device 200 (the surface of the second silicon carbide layer 30), and energy of the laser is nonlinearly absorbed and is focused for ablation at an interface between the second silicon carbide layer 30 and the SiO2 dielectric layer 20. In this way, the second silicon carbide layer 30 in the wafer 100 is debonded from the SiO2 dielectric layer 20, to thin the wafer 100.

Corrosion and cleaning are performed at the surface of the first silicon carbide layer 10, to remove the residue of the SiO2 dielectric layer 20, and a subsequent technological process is performed.

Corrosion and cleaning are performed on the debonded second silicon carbide layer 30, and the second silicon carbide layer 30 continues to be reused to prepare the wafer 100.

Alternatively, for example, in the semiconductor component 1000, the wafer 100 includes a high-quality monocrystalline first silicon carbide layer 10 whose thickness is 2 µm, a Pt dielectric layer 20 whose thickness is 20 nm, and a low-quality monocrystalline second silicon carbide layer 30 whose thickness is 350 µm.

Si substrates of a same size are selected as the temporary substrate carrier 50, and temporary bonding is performed between the temporary substrate carrier 50 and the functional device 200 of the semiconductor component 1000. A bonding temperature is 210°C.

An infrared laser with a wavelength of 980 nm is used to perform scanning and irradiation from the surface that is of the wafer 100 and that is away from the functional device 200 (the surface of the second silicon carbide layer 30). The energy of the laser is nonlinearly absorbed and is focused for ablation at the interface between the second silicon carbide layer 30 and the SiO2 dielectric layer 20. In this way, the second silicon carbide layer 30 in the wafer 100 is debonded from the SiO2 dielectric layer 20, to thin the wafer 100.

Corrosion and cleaning are performed at the surface of the first silicon carbide layer 10, to remove the residue of the SiO2 dielectric layer 20, and the subsequent technological process is performed.

Corrosion and cleaning are performed on the debonded second silicon carbide layer 30, and the second silicon carbide layer 30 continues to be reused to prepare the wafer 100.

According to the method for thinning a wafer provided in this embodiment of this application, in the semiconductor component 1000, the wafer 100 is of a sandwich stacked structure and includes the dielectric layer 20, and a refractive index of the dielectric layer 20 is different from that of the second silicon carbide layer 30. Therefore, after the laser is irradiated into the wafer 100 from the surface that is of the second silicon carbide layer 30 and that is away from the first silicon carbide layer 10, the laser is easily focused and absorbed at the interface between the dielectric layer 20 and the second silicon carbide layer 30. The energy of the laser is increased to reach a melting point of the dielectric layer 20, so that the second silicon carbide layer 30 can be debonded from the first silicon carbide layer 10, to thin the wafer 100. The debonded second silicon carbide layer 30 can be reused to prepare the new wafer 100. Therefore, the composite substrate in the semiconductor component is thinned by using the method for thinning a wafer provided in this embodiment of this application, so that preparation costs of the semiconductor component can be reduced.

In addition, the process of thinning the wafer 100 is performed after the switch functional component 300 is formed. Therefore, the method for thinning a wafer provided in this embodiment of this application is compatible with the high-temperature process in the semiconductor component preparation process.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for thinning a wafer, wherein the wafer comprises a first silicon carbide layer, a dielectric layer, and a second silicon carbide layer that are disposed in a stacked manner, the wafer has a first side and a second side that are opposite to each other, and a side that is of the second silicon carbide layer and that is away from the first silicon carbide layer is the first side of the wafer; and
the method for thinning a wafer comprises:
temporarily bonding a temporary substrate carrier to the wafer on the second side; and
performing laser irradiation on the wafer from the first side, so that energy of a laser is focused for ablation at an interface between the second silicon carbide layer and the dielectric layer, and the second silicon carbide layer is separated from the dielectric layer.

2. The method for thinning a wafer according to claim 1, wherein an absorption coefficient of the second silicon carbide layer for the laser is less than an intrinsic absorption coefficient.

3. The method for thinning a wafer according to claim 1, wherein non-linear absorption of the laser occurs at the interface between the second silicon carbide layer and the dielectric layer.

4. The method for thinning a wafer according to claim 1, wherein a bonding temperature of temporary bonding is less than or equal to 300°C.

5. The method for thinning a wafer according to claim 1, wherein a melting point of the temporary substrate carrier is greater than a bonding temperature of temporary bonding.

6. The method for thinning a wafer according to claim 1, wherein the temporarily bonding a temporary substrate carrier to the wafer on the second side comprises:
temporarily bonding the temporary substrate carrier to the wafer on the second side by using temporary bonding adhesive or paraffin.

7. The method for thinning a wafer according to claim 1, wherein the performing laser irradiation on the wafer from the first side comprises:
performing laser irradiation on the wafer from the first side by using an infrared laser.

8. The method for thinning a wafer according to claim 1, further comprising:
processing a surface that is of the first silicon carbide layer and that is away from the temporary substrate carrier, to remove a residue of the dielectric layer.

9. The method for thinning a wafer according to claim 8, wherein the processing a surface that is of the first silicon carbide layer and that is away from the temporary substrate carrier comprises:
processing, through at least one of wet etching, dry etching, or cleaning, the surface that is of the first silicon carbide layer and that is away from the temporary substrate carrier.

10. The method for thinning a wafer according to any one of claims 1 to 9, wherein a switch functional component is further disposed on the second side of the wafer; and
the temporarily bonding a temporary substrate carrier to the wafer on the second side comprises:
temporarily bonding the temporary substrate carrier to the switch functional component.
